# EUROPEAN PATENT SPECIFICATION

(11) **EP 1 076 356 B1**
(45) Date of publication and mention of the grant of the patent: **13.09.2006**
(21) Application number: 00306880.6
(22) Date of filing: 11.08.2000
(51) Int. Cl.: H01L 21/00, B08B 3/12, B08B 3/04

(54) **Wet treatment nozzle, nozzle device and wet treatment apparatus**
Nassbehandlungsdüse, Düsevorrichtung und Nassbehanlungsvorrichtung
Buse de traitement humide, buse et dispositif de traitement humide

(30) Priority: 13.08.1999 JP 22949799
(43) Date of publication of application: 14.02.2001
(73) Proprietor: ALPS ELECTRIC CO., LTD., Ota-ku Tokyo 145 (JP); KAIJO CORPORATION, Tokyo (JP)
(72) Inventor: Haga, Nobuaki, c/o FRONTEC INCORPORATED, Sendai-shi, Miyagi-ken (JP); Mitsumori, Kenichi, c/o FRONTEC INCORPORATED, Sendai-shi, Miyagi-ken (JP); Kasama, Yasuhiko, c/o FRONTEC INCORPORATED, Sendai-shi, Miyagi-ken (JP)
(74) Representative: Kensett, John Hinton

(56) References cited:
- US-A- 4 846 202
- PATENT ABSTRACTS OF JAPAN vol. 1999, no. 05, 31 May 1999 (1999-05-31) & JP 11 033506 A (OMI TADAHIRO;FURONTETSUKU:KK; JAPAN ORGANO CO LTD), 9 February 1999 (1999-02-09) & US 6 230 722 A (ALPS ELECRIC CO) 15 May 2001 (2001-05-15)

## Description

The present invention relates to a wet treatment nozzle for supplying a treatment liquid onto a substrate in a wet treatment process such as a cleaning process, etching process and the like in the manufacturing process of, for example, a semiconductor device, liquid crystal panel and the like, and to a nozzle device and a wet treatment apparatus having the nozzle device.

In the field of electronic devices such as semiconductor devices, liquid crystal panels and the like, a process for cleaning semiconductor substrates and glass substrates as substrates to be treated is essential in the manufacturing process thereof. In the cleaning process, cleaning is carried out using various cleaning liquids such as ultra-pure water, electrolytic ion water, ozone water, hydrogen water, and the like to remove various types of substances to be removed in the manufacturing process, and these cleaning liquids are supplied from the nozzle of a cleaning device onto a substrate. However, when a conventional cleaning nozzle is used, there is arisen a problem that an increased amount of a cleaning liquid is used. When, for example, a substrate of 500 mm × 500 mm is cleaned using a cleaning liquid such as electrolytic ion water or the like and then rinsed with a rinse cleaning liquid so that the level of cleanness of 0.5 piece/cm² is achieved as a remaining amount of particles on the substrate, each 25 to 30 litters/min of the cleaning liquid and the rinse cleaning liquid must be used.

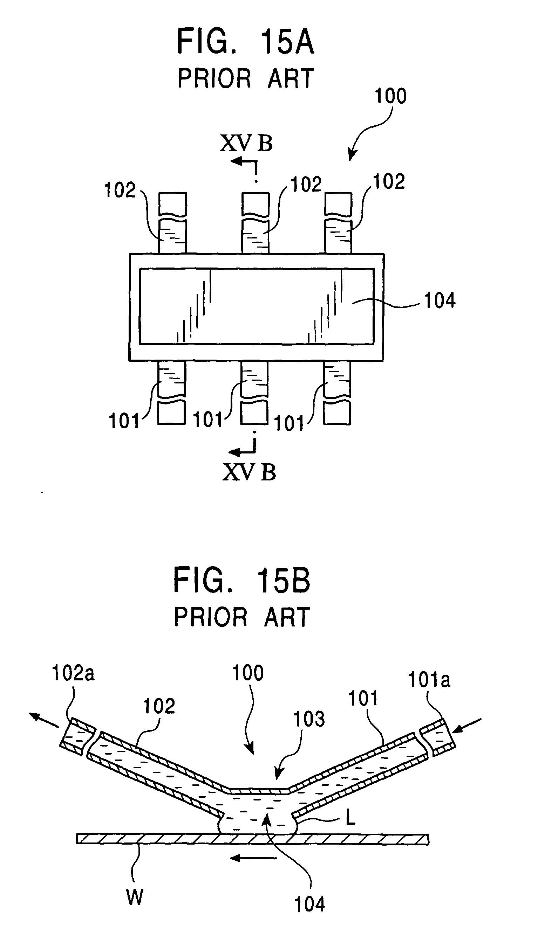

To cope with the above problem, the applicant has filed a cleaning liquid saving type cleaning nozzle by which an amount of a cleaning liquid can be greatly reduced. Figs. 15A and 15B show an example of this type of a cleaning nozzle. Fig. 15A is a lower plan view of the cleaning nozzle and Fig. 15B is a side sectional view taken along the line XV - XV of Fig. 15A. As shown in these figures, a cleaning nozzle 100 includes introduction paths 101 and discharge paths 102. Each of the introduction paths 101 has an introduction port 101a formed at an end thereof to introduce a cleaning liquid L, and each of the discharge paths 102 has a discharge port 102a formed at an end thereof to discharge the cleaning liquid L after it is used to the outside of a system. The introduction path 101 intersects the discharge path 102 at the other ends thereof, and the portion where they intersect each other is arranged as an intersect section 103 having an opening 104 which opens toward a substrate W. Further, a pressure reduction pump (not shown) is connected to the discharge ports 102a of the discharge paths 102, and the difference between the pressure of the cleaning liquid L which is in contact with the atmosphere (the pressure including the surface tension of the cleaning liquid L and the surface tension of the surface to be cleaned of the substrate W) and the atmospheric pressure can be controlled by controlling the suction pressure of the pressure reduction pump.

That is, the cleaning liquid L which is supplied to the substrate W through the opening 104 and comes into contact therewith is discharged to the discharge paths 102 without leaking to the outside of the cleaning nozzle 100 by setting the relationship between the pressure P_{w} of the cleaning liquid L which is in contact with the atmosphere of the opening 104 (the pressure including the surface tension of the cleaning liquid L and the surface tension of the surface to be cleaned of the substrate W) to Pw = Pa. As a result, the cleaning liquid L supplied from cleaning nozzle 100 onto the substrate W is removed from on the substrate W without coming into contact with the portion other than that from which the cleaning liquid L is supplied onto the substrate W (opening 104). With this arrangement, the proposed cleaning nozzle can greatly reduce an amount of the cleaning liquid used as compared with a conventional nozzle.

However, the above liquid saving type cleaning nozzle has the following problems.

In the above cleaning nozzle, since both the cleaning liquid introduction paths and the cleaning liquid discharge paths are formed in pipe-shaped paths, a region where the cleaning liquid flows rapidly is limited to a certain extent of the intersect section. Accordingly, the cleaning liquid flows on the substrate at high speed at a portion thereof and at low speed at the other portion thereof, thus there is a possibility that the substrate is cleaned irregularly. Moreover, in the conventional nozzle, a so-called "liquid reservoir", where the cleaning liquid does not almost flow and stays, is formed under the intersect section as shown in Fig. 15, in relation also to that the end of the intersect section, which corresponds to the outsides of the introduction paths and the discharge paths, is formed in a collar. Since particles on the substrate are gathered in the liquid reservoir, a cleaning efficiency is reduced thereby. The problem of the reduction of the cleaning efficiency caused by the occurrence of the liquid reservoir is not a problem relating only to cleaning but a problem common to a wet treatment process.

Further prior art arrangements are known from JP-A- 11033506, corresponding to US-B-6230722 and from US-A-4846202. US-B-6230722 and JP-A- 11033506 discloses a wet treatment nozzle for supplying a substrate to be treated with a treatment liquid, comprising: introduction paths having introduction ports, formed at one end thereof, for introducing the treatment liquid; discharge paths having discharge ports, formed at one end thereof, for discharging the treatment liquid after it is used to the outside, according to the preamble of claim 1. US-A-4846202 discloses a treatment liquid supply member having a multiplicity of through holes in an introduction opening. In this arrangement the flow concentrates at the holes and diverges therefrom,

An object of the present invention is to provide a wet treatment nozzle capable of improving a treatment efficiency by preventing the occurrence of a liquid reservoir between the nozzle and a substrate as far as possible and making more use of the advantage of a liquid saving type nozzle, and to provide a nozzle device having the nozzle and a wet treatment apparatus.

According to an aspect of the present invention there is provided a wet treatment nozzle for supplying a substrate to be treated with a treatment liquid, comprising: introduction paths having introduction ports, formed at one end thereof, for introducing the treatment liquid; discharge paths having discharge ports, formed at one end thereof, for discharging the treatment liquid after it is used to the outside, characterised by an introduction opening disposed to the other ends of said introduction paths and opening toward the lower surface of the nozzle; a discharge opening disposed to the other ends of said discharge paths and opening toward the lower surface of the nozzle; and a treatment liquid supply member, accommodated in said introduction opening, composed of a porous material and having a multiplicity of through holes for supplying the treatment liquid to the substrate according to claim 1.

The one ends of the discharge paths may be connected to a pressure reduction pump so as to control the difference between the pressure of the treatment liquid in contact with the atmospheric pressure at the opening and the atmospheric pressure by controlling the suction pressure of the pressure reduction pump.

In a conventional nozzle, introduction paths are arranged as ordinary pipe-shaped paths. Thus, in the structure of the conventional nozzle, while a treatment liquid flows relatively well to the portions at the extreme ends of the pipe-shaped paths in openings, the liquid is liable to stay at the portions other than the above portion or the liquid does not flow uniformly. To cope with the above problem, the treatment liquid supply member having the multiplicity of through holes is preferably disposed to the introduction opening located at the other ends of the introduction paths to supply the treatment liquid onto the substrate. That is, the treatment liquid does not directly flow down onto the substrate from the openings of the introduction paths but it is supplied onto the substrate through the multiplicity of through holes of the treatment liquid supply member composed of, for example, the porous material. As a result, the treatment liquid is approximately uniformly supplied from the overall surface, which faces the substrate, of the cleaning liquid supply member, whereby the cleaning liquid is uniformly and rapidly supplied onto a certain extent of wide area on the substrate at an approximately uniform flow rate. Therefore, a liquid reservoir is not almost formed and the efficiency of a wet treatment can be improved as compared with the conventional nozzle.

Further, it is preferable that a treatment liquid discharge member having a multiplicity of through holes for discharging the treatment liquid from the substrate to the outside be accommodated in the discharge opening.

While the introduction paths are described above, the discharge paths also are arranged similarly to the introduction paths. That is, the provision of the treatment liquid discharge member having the multiplicity of through hole with the discharge opening located at the other ends of the discharge paths to discharge the treatment liquid from the substrate permits the treatment liquid to be approximately uniformly discharged from the entire surface, which faces the substrate, of the treatment liquid discharge member. Therefore, the discharge means also contributes to the prevention of a liquid reservoir, whereby the efficiency of the wet treatment can be more improved. In addition, a diameter of the multiplicity of through holes defined to the treatment liquid discharge member may be larger than that of the through holes defined to the treatment liquid supply member in accordance with the size of pollutants on the substrate.

It is preferable that a part of the treatment liquid supply member on the side thereof which is at least in contact with the treatment liquid on the substrate be formed of a hydrophilic material. Likewise, it is preferable that a part of the treatment liquid discharge member on the side thereof which is at least in contact with the treatment liquid on the substrate be formed of a hydrophilic material.

When the treatment liquid supply member and the treatment liquid discharge member are formed of the hydrophilic material, the space between the treatment liquid supply member and treatment liquid discharge member and the substrate can be easily filled with the treatment liquid, thus the treatment liquid can be rapidly supplied onto the substrate and rapidly discharged therefrom. Further, since the treatment liquid can be easily held in the space between the treatment liquid supply member and treatment liquid discharge member and the substrate, the treatment liquid in the space can be reliably held. With this arrangement, the efficiency of the wet treatment can be improved.

An ultrasonic oscillation application means may be interposed between the introduction opening and the discharge opening to apply ultrasonic oscillation to the treatment liquid on the substrate.

When the ultrasonic oscillation application means is disposed between the introduction opening and the discharge opening, the ultrasonic oscillation can be applied to the treatment liquid on the substrate, whereby a cleaning efficiency can be improved by carrying out, for example, ultrasonic cleaning and the like.

Further, it is preferable that at least the periphery of the introduction opening including the treatment liquid supply member be formed of a hydrophobic material. Likewise, it is preferable that at least the periphery of the discharge opening including the treatment liquid discharge member be formed of a hydrophobic material.

With the above arrangement, since the flow of the treatment liquid, which tends to leak from the introduction opening and the discharge opening, which are released to the atmosphere, to the outside of the nozzle, is suppressed and the interfacial tension of the member at the end of the opening is reduced, the treatment liquid is held between the nozzle and the substrate while swelling. Accordingly, controllability as to the holding the cleaning liquid L is greatly improved and the cleaning liquid L can be reliably prevented from leaking to the outside of the nozzle.

While one set of the introduction path may be provided, a plurality of sets of them may be provided in a direction in which the substrate moves relatively to them and the treatment liquid supply member may be disposed to each of them.

With this arrangement, the wet treatment can be carried out by various sequences. That is, the wet treatment can be more efficiently carried out using the plurality of introduction paths by providing, for example, one of the introduction paths a role for promptly supplying the treatment liquid between the nozzle and the substrate at an early stage and by providing other introduction path with a role for supplying the treatment liquid to be used when the treatment is continued steadily.

A wet treatment nozzle device preferably includes a draw and discharge means for drawing and discharging a treatment liquid having been in contact with a substrate through an introduction opening after the treatment liquid is treated through discharge paths by controlling the difference between the pressure of the treatment liquid in contact with the substrate and the atmospheric pressure to prevent the treatment liquid from flowing to the outside of discharge paths.

Since the wet treatment nozzle device includes means for drawing and discharging the treatment liquid on the substrate through the discharge paths by controlling the difference between the pressure of the treatment liquid in contact with the substrate and the atmospheric pressure, the treatment liquid can be removed from the substrate without causing the treatment liquid to come into contact with the portions other than portion from which the treatment liquid is supplied.

A wet treatment apparatus preferably includes
a movement means for moving the wet treatment nozzle or a substrate for treating the overall surface to be treated of the substrate by relatively moving the wet treatment nozzle and the substrate along the surface to be treated of the substrate.

Since the wet treatment apparatus includes
the movement means for relatively moving the wet treatment nozzle and the substrate along the surface to be treated of the substrate, the apparatus can treat the overall area of the surface to be treated of the substrate while including the advantage of the wet treatment nozzle.

In the above wet treatment apparatus, at least each one set of the wet treatment nozzle may be disposed to the one surface side of the substrate and to the other surface side thereof so that both the surfaces of the substrate can be treated.

With this arrangement, both the surfaces of the substrate can be treated, and, for example, the front and back surfaces of the substrate can be simultaneously cleaned.

Further, an ultrasonic oscillation application means may be disposed to any one of the wet treatment nozzles disposed to the one surface side and the other surface side of the substrate to apply ultrasonic oscillation to the treatment liquid on the substrate.

With this arrangement, the ultrasonic vibration can be applied to the treatment liquid on the substrate, and a cleaning device having a high cleaning efficiency can be realized by carrying out, for example, ultrasonic cleaning and the like.

Embodiments of the present invention will now be described by way of example only, with reference to the accompanying schematic drawings, in which:
Fig. 1 is a perspective view showing the outside appearance of a cleaning nozzle of a first embodiment of the present invention;
Fig. 2A is a lower plan view of the cleaning nozzle and Fig. 2B is a sectional view taken along the line IIB - IIB of Fig. 2A;
Fig. 3 is a view explaining the operation of the cleaning nozzle;
Fig. 4 shows a cleaning nozzle of a second embodiment of the present invention, wherein Fig. 4A is a lower plan view of the cleaning nozzle, and Fig 4B is a sectional view taken along the line IV - IV of Fig. 4A;
Fig. 5 shows a cleaning nozzle of a third embodiment of the present invention, wherein Fig. 5A is a lower plan view of the cleaning nozzle, and Fig 5B is a sectional view taken along the line V - V of Fig. 5A;
Fig. 6 is a view explaining the operation of the cleaning nozzle;
Fig. 7 shows a cleaning nozzle of a fourth embodiment of the present invention, wherein Fig. 7A is a lower plan view of the cleaning nozzle, and Fig 7B is a sectional view taken along the line VII - VII of Fig. 7A;
Fig. 8 shows a cleaning nozzle of a fifth embodiment of the present invention, wherein Fig. 8A is a lower plan view of the cleaning nozzle, and Fig 8B is a sectional view taken along the line VIII - VIII of Fig. 8A;
Fig. 9 is a view explaining the operation of the cleaning nozzle;
Fig. 10 shows a cleaning nozzle of a sixth embodiment of the present invention, wherein Fig. 10A is a lower plan view of the cleaning nozzle, and Fig 10B is a sectional view taken along the line X - X of Fig. 10A;
Fig. 11 shows a cleaning nozzle of a seventh embodiment of the present invention, wherein Fig. 11A is an upper plan view of the cleaning nozzle, and Fig 11B is a sectional view taken along the line XI - XI of Fig. 11A;
Fig. 12 shows a cleaning nozzle of an eighth embodiment of the present invention, wherein Fig. 12A is an upper plan view of the cleaning nozzle, and Fig 12B is a sectional view taken along the line XII - XII of Fig. 12A;
Fig. 13 shows a cleaning nozzle of a ninth embodiment of the present invention, wherein Fig. 13A is an upper plan view of the cleaning nozzle, and Fig 13B is a sectional view taken along the line XIII - XIII of Fig. 13A;
Fig. 14 is a plan view showing the schematic arrangement of a cleaning device of a tenth embodiment of the present invention; and
Fig. 15 is a view showing an example of a conventional liquid saving type cleaning nozzle, wherein Fig. 15A is a lower plan view of the cleaning nozzle, and Fig 15B is a sectional view taken along the line XV - XV of Fig. 15A.

### [First embodiment]

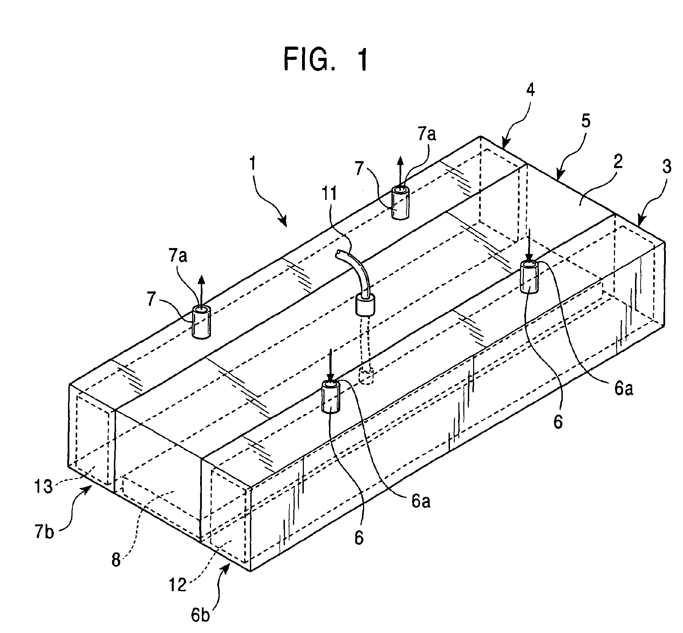

A first embodiment of the present invention will be described below with reference to Figs. 1 to 3.

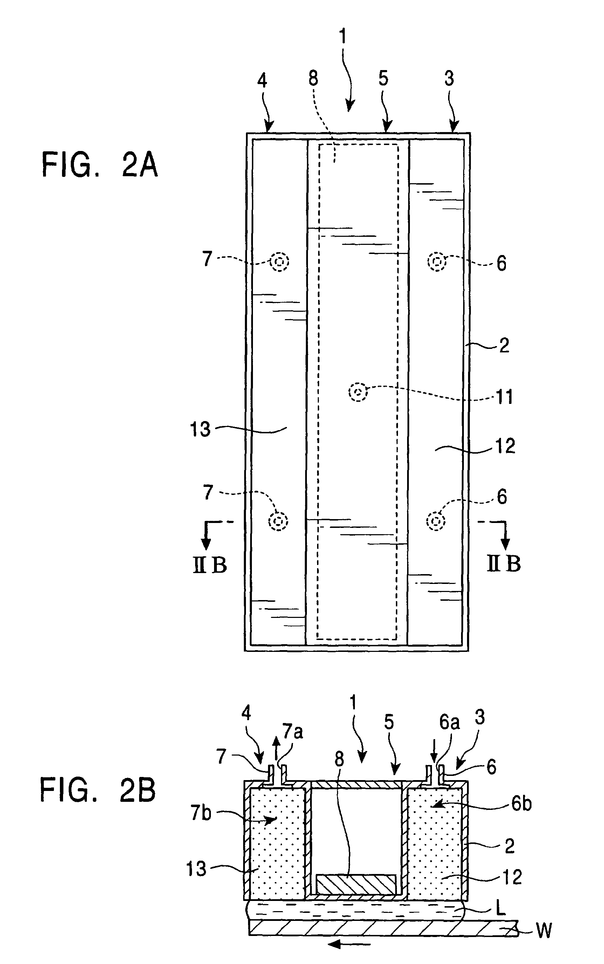

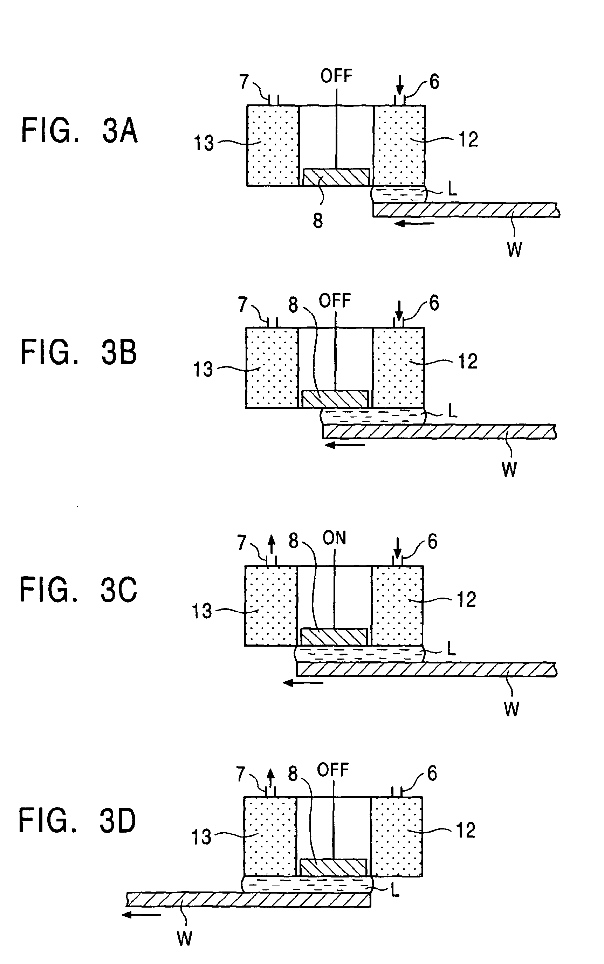

Fig. 1 is a perspective view showing the outside appearance of a cleaning nozzle (wet treatment nozzle) of the first embodiment, Fig. 2A is a lower plan view of the cleaning nozzle, Fig. 2B is a sectional view taken along the line IIB - IIB of Fig. 2A, and Fig. 3 is a view explaining the operation of the cleaning nozzle.

As shown in Figs. 1 and 2A, the cleaning nozzle 1 of the first embodiment has a casing 2 divided into three regions in the short side direction thereof, the opposite end regions of the casing 2 are arranged as a cleaning liquid introduction section 3 and a cleaning liquid discharge section 4, respectively, and the central region thereof is arranged as an ultrasonic oscillator accommodating section 5. Two cleaning liquid introduction pipes 6 (introduction paths), which are spaced apart from each other in the longitudinal direction of the nozzle, are disposed on the upper surface of the cleaning liquid introduction section 3, and two cleaning liquid discharge pipes 7 (discharge paths) are disposed on the upper surface of the cleaning liquid discharge section 4 likewise. The upper ends of the respective cleaning liquid introduction pipes 6 are opened so as to act as introduction ports 6a from which a cleaning liquid L (treatment liquid) is introduced, and the lower ends thereof are arranged as an introduction opening 6b which opens toward a substrate to be treated W (hereinafter, simply referred to as "substrate") in the interior of the casing 2. Similarly, the upper ends of the respective cleaning liquid discharge pipes 7 are opened so as to act as discharge ports 7a from which the cleaning liquid L is discharged to the outside after it is used, and the lower ends thereof are arranged as a discharge opening 7b which opens toward the substrate W in the interior of the casing 2. The discharge ports 7a of the cleaning liquid discharge pipes 7 are connected to a pressure reduction pump (not shown). The difference between the pressure of the cleaning liquid L having been used and the atmospheric pressure is controlled by controlling the suction force of the pressure reduction pump so that the cleaning liquid L is reliably discharged.

Further, an ultrasonic oscillator 8 (ultrasonic oscillation application means) is accommodated in the interior of the ultrasonic oscillator accommodating section 5 to perform ultrasonic cleaning by applying ultrasonic oscillation to the cleaning liquid L. A cable 11 is disposed at the central portion of the ultrasonic oscillator accommodating section 5 to control the ultrasonic oscillator 8.

As shown in Fig. 2B, a cleaning liquid supply member 12 (treatment liquid supply member) composed of a porous material is accommodated in the interior of the introduction opening 6b. As the porous material, there can specifically be used plastic such as fluorine resin, polyethylene, etc., metal such as SUS 316, etc., ceramics such as alumina, silicon oxide, etc. plastic whose surface is subjected to a hydrophilic treatment to provide it with a hydrophilic group, metal oxide such as TiO₂. Among them, a hydrophilic material such as silicon oxide and alumina as well as plastic, etc. subjected to the hydrophilic treatment can more preferably be used. Otherwise, at least only the portion, which is in contact with the cleaning liquid L on the substrate W, of the cleaning liquid supply member 12, may be formed of the hydrophilic material or the surface of the cleaning liquid supply member 12 may be subjected to the hydrophilic treatment in place of the cleaning liquid supply member 12 which is entirely composed of the hydrophilic material. In any case, since the cleaning liquid supply member 12 is composed of the porous material, when the cleaning liquid L is supplied from the cleaning liquid introduction pipes 6 into the introduction opening 6b, the cleaning liquid L is supplied onto the substrate W through the multiplicity of through-holes of the cleaning liquid supply member 12.

In contrast, a cleaning liquid discharge member 13 (treatment liquid discharge member) composed of a porous material also is accommodated in the interior of the discharge opening 7b. The porous material used in the cleaning liquid supply member 12 can also be used as the porous material used in the cleaning liquid discharge member 13. However, the same or a different porous material may be used in the cleaning liquid supply member 12 and the cleaning liquid discharge member 13 in the same one nozzle. Since the cleaning liquid discharge member 13 is formed on the porous material, the used cleaning liquid L remaining on the substrate W is drawn from the multiplicity of through holes of the cleaning liquid discharge member 13 and discharged to the outside of the nozzle through the cleaning liquid discharge pipes 7.

Next, an example of the operation (sequence) of the cleaning nozzle 1 arranged as described above will be described using Figs. 3A to 3D. When a liquid saving type nozzle as described in the paragraph of related art is realized using the cleaning nozzle 1, a nozzle device is arranged such that a discharge pump (not shown) is connected to the cleaning liquid discharge pipes 7 to control the difference between the pressure of the cleaning liquid L and the atmospheric pressure in order prevent the cleaning liquid L on the substrate W from flowing to the outside of the space between the nozzle and the substrate W and to draw and discharge the cleaning liquid through the cleaning liquid discharge pipes 7. Further, an optional cleaning liquid supply means is connected to the cleaning liquid introduction pipes 6.

Note that, in the description of Figs. 3A to 3D, the substrate W is moved from right to left with respect to the cleaning nozzle 1 (the moving direction of the substrate is shown by arrows).

First, as shown in Fig. 3A, when the left end of the substrate W approaches below the cleaning liquid supply member 12, the cleaning liquid L is supplied from the cleaning liquid supply member 12 onto the substrate W. At that time, the ultrasonic oscillator 8 is not yet operated.

When the substrate W is further moved, while the cleaning liquid L flows under the ultrasonic oscillator 8 as shown in Fig. 3B, the ultrasonic oscillator 8 is not yet operated also at that time.

The discharge pump is operated when the substrate W is further moved and arrives below the cleaning liquid discharge member 13 as shown in Fig. 3C to discharge the cleaning liquid L supplied from the cleaning liquid supply member 12 onto the substrate W from the cleaning liquid discharge member 13. Since the cleaning liquid L flows on the substrate W steadily at this stage, the ultrasonic oscillator 8 is operated simultaneously with the steady flow of the cleaning liquid L, whereby the substrate W is subjected to ultrasonic cleaning.

Finally, when the right end of the substrate W passes below the cleaning liquid supply member 12 as shown in Fig. 3D, the supply of the cleaning liquid L and the operation of the ultrasonic oscillator 8 are stopped. Then, the cleaning liquid L remaining on the substrate W is discharged from the cleaning liquid discharge member 13 finally. With this operation, the overall region of the substrate can be subjected to the ultrasonic cleaning by the device.

In the cleaning nozzle 1 of the first embodiment, the cleaning liquid is supplied onto the substrate W through the multiplicity of through holes of the cleaning liquid supply member 12 composed of the porous material different from the conventional nozzle in which the cleaning liquid is directly dropped from an introduction pipe onto the substrate. As a result, the cleaning liquid L is approximately uniformly supplied from the overall surface, which faces the substrate W, of the cleaning liquid supply member 12, whereby the cleaning liquid is uniformly and rapidly supplied onto a certain extent of wide area on the substrate W at an approximately uniform flow rate. Then, the cleaning liquid L is discharged approximately uniformly from the overall surface, which faces the substrate W, of the cleaning liquid discharge member 13 having the multiplicity of through holes. Since a liquid reservoir is not almost formed in the cleaning nozzle 1 of the first embodiment by the actions of both the cleaning liquid supply member 12 and the cleaning liquid discharge member 13, no particle is stored accordingly, whereby a cleaning efficiency can be improved as compared with the conventional nozzle.

Further, when the cleaning liquid supply member 12 and the cleaning liquid discharge member 13 are composed of the hydrophilic material, the overall space between the cleaning liquid supply member 12 and cleaning liquid discharge member 13 and the substrate W can be easily filled with the cleaning liquid L. Thus, the cleaning liquid L can promptly be supplied onto the substrate W and promptly be discharged therefrom. The cleaning efficiency can be more improved thereby. Further, in the first embodiment, since ultrasonic oscillation can be applied to the cleaning liquid L on the substrate W by the ultrasonic oscillator 8, a degree of cleanness of the substrate W can be more improved by the ultrasonic cleaning.

### [Second embodiment]

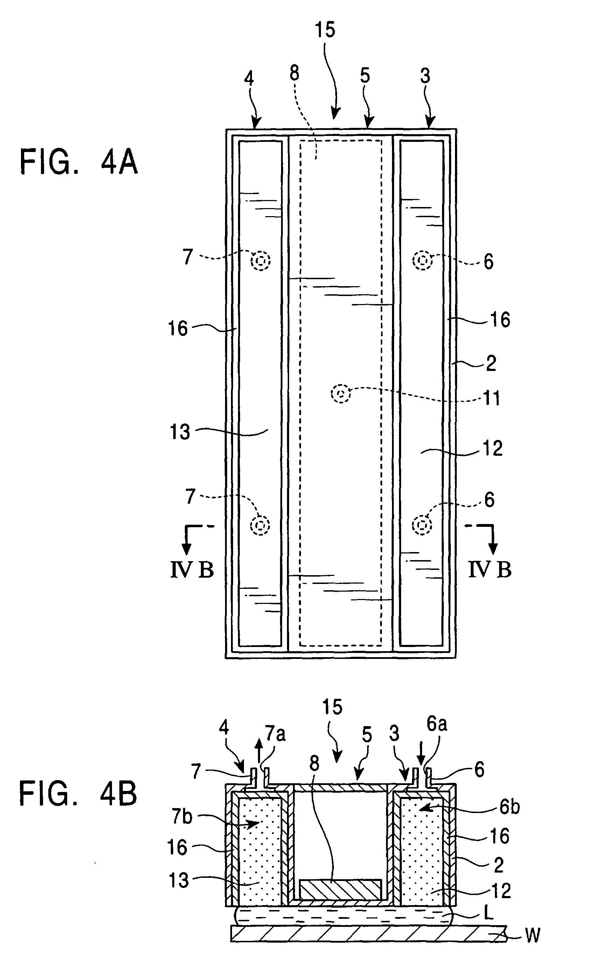

A second embodiment of the present invention will be described below with reference to Figs. 4A and 4B. Fig. 4A is a lower plan view of a cleaning nozzle (wet treatment nozzle) of the second embodiment and Fig 4B is a sectional view taken along the line IV - IV of Fig. 4A.

The cleaning nozzle of the second embodiment is basically arranged similarly to that of the first embodiment except that a layer composed of a hydrophobic material is added to a part of the arrangement of the first embodiment. Thus, in Figs. 4A and 4B, the components common to those in Figs. 2A and 2B are denoted by the same numerals and the detailed description thereof is omitted.

The cleaning nozzle 15 of the second embodiment is arranged such that the peripheries of a cleaning liquid supply member 12 and a cleaning liquid discharge member 13 are covered with hydrophobic layers 16 composed of a hydrophobic material, respectively as shown in Figs. 4A and 4B. Teflon resin, silicone resin, polyethylene resin, etc., for example, can be used as the hydrophobic material. While the overall peripheries of the cleaning liquid supply member 12 and the cleaning liquid discharge member 13 are covered with the hydrophobic layers 16 in the second embodiment, the overall peripheries need not necessarily be covered therewith and it is sufficient that at least the ends thereof facing a substrate W is covered thereby.

In the cleaning nozzle 15 of the second embodiment, since the flow of a cleaning liquid L, which tends to leak from an introduction opening 6b and a discharge opening 7b, which are released to the atmosphere, to the outside of the nozzle, is suppressed and the surface tension of the cleaning liquid L is reduced at the ends of the openings, the cleaning liquid L is held between the cleaning nozzle 15 and the substrate W while swelling. Accordingly, controllability as to the holding the cleaning liquid L is greatly improved and the cleaning liquid L can be reliably prevented from leaking to the outside of the nozzle.

### [Third embodiment]

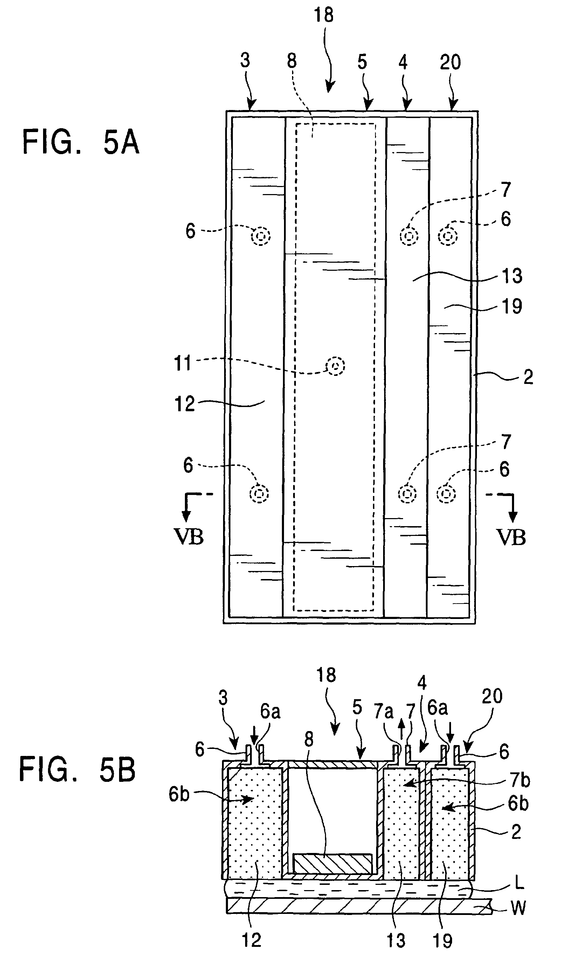

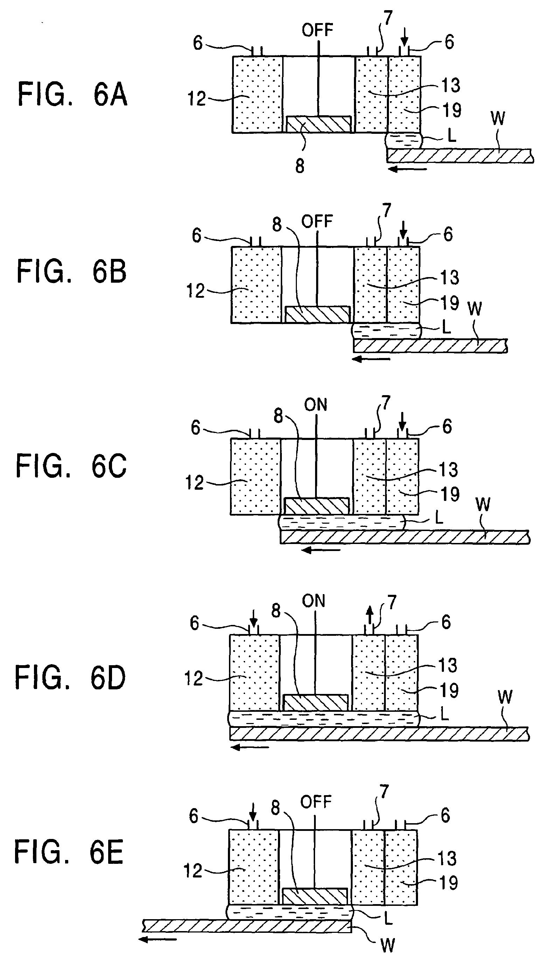

A third embodiment of the present invention will be described below with reference to Figs. 5A, 5B and 6. Fig. 5A is a lower plan view of a cleaning nozzle (wet treatment nozzle) of the third embodiment, Fig 5B is a sectional view taken along the line V - V of Fig. 5A, and Fig. 6 is a view explaining the operation of the cleaning nozzle.

The cleaning nozzle of the third embodiment is basically arranged similarly to that of the first embodiment except that a cleaning liquid supply member is additionally provided. Thus, in Figs. 5A and 5B, the components common to those in Figs. 2A and 2B are denoted by the same numerals and the detailed description thereof is omitted. However, the direction of the nozzle in Figs. 5A and 5B is reversed 180° from that in Figs. 2A and 2B.

A casing 2 is divided into 4 regions in the cleaning nozzle 18 of the third embodiment as shown in Figs. 5A and 5B, the cleaning liquid supply member 19 is additionally accommodated externally of a cleaning liquid discharge member 13 and this region constitutes a cleaning liquid supply section 20. In the following description, a cleaning liquid supply member 12 which is originally provided is referred to as a "first cleaning liquid supply member" and the cleaning liquid supply member 19 which is newly added externally of the cleaning liquid discharge member 13 is referred to as a "second cleaning liquid supply member". A porous material which constitutes the second cleaning liquid supply member 19 may be the same as that of the first cleaning liquid supply member 12. Then, a cleaning liquid L is supplied also to the second cleaning liquid supply member 19 from cleaning liquid introduction pipes 6 likewise the first cleaning liquid supply member 12.

Next, an example of the operation (sequence) of the cleaning nozzle 18 arranged as described above will be described using Figs. 6A to Fig. 6D. Note that, in the description of Figs. 6A to 6D, a substrate W is moved from right to left with respect to the cleaning nozzle 18 (the moving direction of the substrate is shown by arrows).

First, as shown in Fig. 6A, when the left end of a substrate W approaches below the second cleaning liquid supply member 19, the cleaning liquid L is supplied from the second cleaning liquid supply member 19 onto the substrate W. At that time, no cleaning liquid L is supplied from the first cleaning liquid supply member 12 and neither a discharge pump nor an ultrasonic oscillator 8 is operated.

When the substrate W is further moved, while the cleaning liquid L flows under the cleaning liquid discharge member 13 as shown in Fig. 6B, neither the discharge pump nor the ultrasonic oscillator 8 is yet operated at that time.

Next, when the cleaning liquid L flows under the ultrasonic oscillator 8 as shown in Fig. 6C, the ultrasonic oscillator 8 is operated to thereby start ultrasonic cleaning. However, the discharge pump is not operated so that the cleaning liquid L is not discharged from the cleaning liquid discharge member 13.

When the substrate W is further moved and arrives below the first cleaning liquid supply member 12 as shown in Fig. 6D, the cleaning liquid supply member 12 starts to supply the cleaning liquid L. At the same time, the cleaning liquid discharge member 13 starts to discharge the cleaning liquid after it is used as well as the second cleaning liquid supply member 19 stops supplying the cleaning liquid L. When this stage is reached, the cleaning liquid L starts to steadily flow between the first cleaning liquid supply member 12 and the cleaning liquid discharge member 13. That is, the first cleaning liquid supply member 12 achieves a role for steadily supplying the cleaning liquid L to the substrate W, and the second cleaning liquid supply member 19 achieves a role for rapidly wetting the substrate W with the cleaning liquid L at an early stage and a role for instantly filling the portion under the ultrasonic oscillator 8 with the cleaning liquid L.

Finally, when the right end of the substrate W passes below the cleaning liquid discharge member 13 as shown in Fig. 6E, the discharge of the cleaning liquid L from the cleaning liquid discharge member 13 and the ultrasonic oscillation are stopped, while the cleaning liquid L is continuously supplied from the first cleaning liquid supply member 12. When the right end of the substrate W passes below the first cleaning liquid supply member 12, the supply of the cleaning liquid from the first cleaning liquid supply member 12 is stopped. With this operation, the overall upper surface the substrate can be subjected to the ultrasonic cleaning.

According to the cleaning nozzle 18 of the third embodiment, the addition of the second cleaning liquid supply member 19, which achieves the role of promptly wetting the substrate W at the early stage and the role for filling the portion under the ultrasonic oscillator 8 with the cleaning liquid, permits a cleaning efficiency to be more improved as compared the nozzle of the first embodiment.

### [Fourth embodiment]

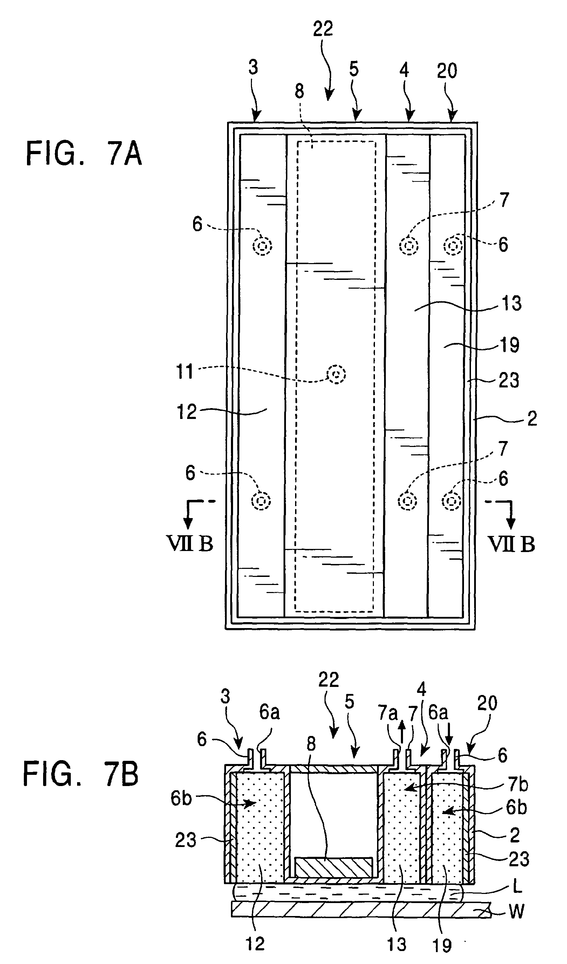

A fourth embodiment of the present invention will be described below with reference to Figs. 7A and 7B. Fig. 7A is a lower plan view of a cleaning nozzle (wet treatment nozzle) of the fourth embodiment and Fig 7B is a sectional view taken along the line VII - VII of Fig. 7A.

The cleaning nozzle of the fourth embodiment is basically arranged similarly to that of the third embodiment except that a hydrophobic layer is added to a part of the arrangement of the third embodiment. Thus, in Figs. 7A and 7B, the components common to those in Figs. 5A and 5B are denoted by the same numerals and the detailed description thereof is omitted.

While the hydrophobic layer is provided also in the second embodiment, the hydrophobic layer 16 of the example described in the second embodiment is formed around the peripheries of the individual members such as the cleaning liquid supply member 12, the cleaning liquid discharge member 13 and the like in the second embodiment (refer to Fig. 4). In contrast, in the cleaning nozzle 22 of the fourth embodiment, the inner periphery of an overall casing 2 is covered with the hydrophobic layer 23 composed of a hydrophobic material as shown in Figs. 7A and 7B. However, the hydrophobic material may be the same as that of the second embodiment and at least the end of the casing 2 on the side thereof facing a substrate W may be covered with the hydrophobic layer 23 similarly to the second embodiment.

An effect similar to that of the second embodiment capable of reliably preventing the leakage of the liquid to the outside of the nozzle can be obtained also in the cleaning nozzle 22 of the fourth embodiment.

### [Fifth embodiment]

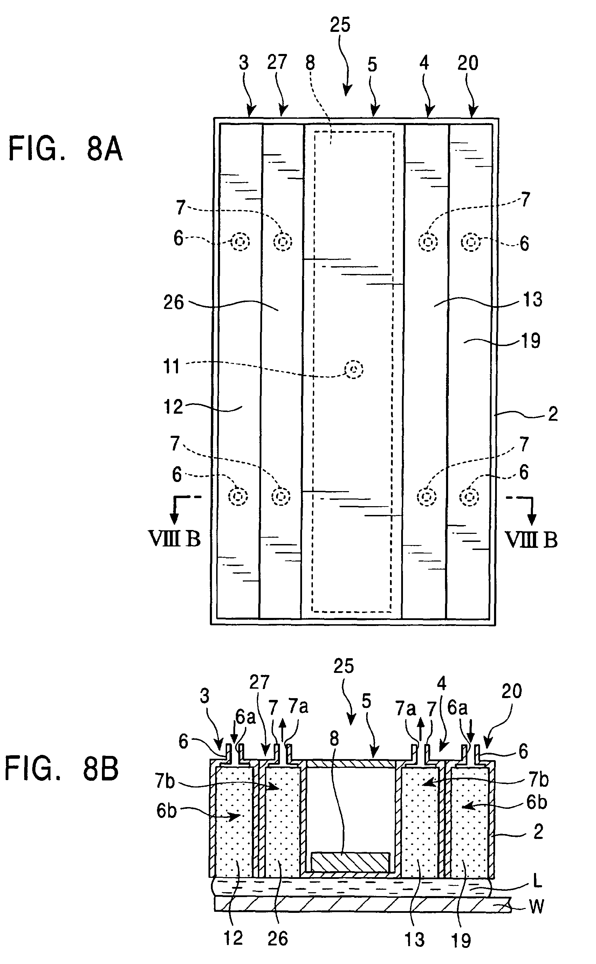

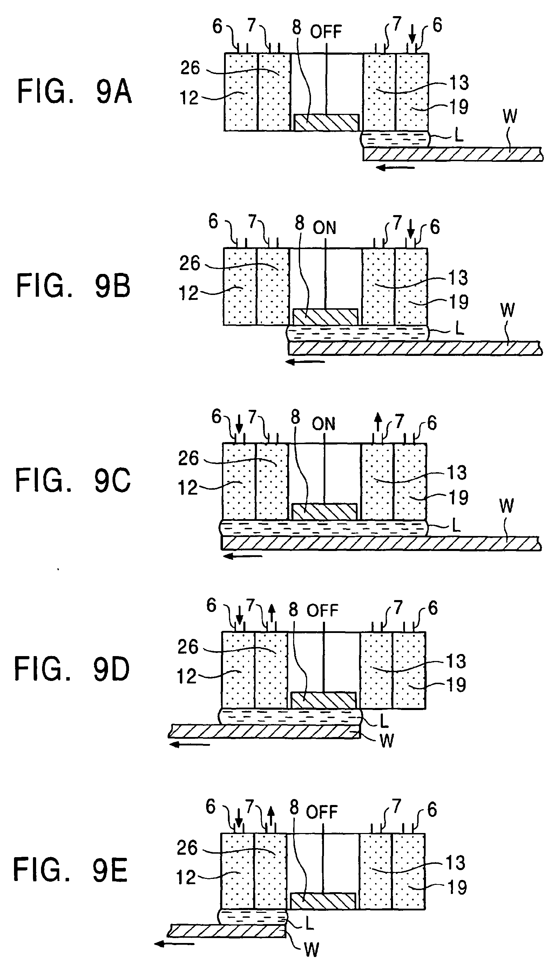

A fifth embodiment of the present invention will be described below with reference to Figs. 8A, 8B and 9. Fig. 8A is a lower plan view of a cleaning nozzle (wet treatment nozzle) of the fifth embodiment, Fig 8B is a sectional view taken along the line VIII - VIII of Fig. 8A, and Fig. 9 is a view explaining the operation of the cleaning nozzle.

The cleaning nozzle of the fifth embodiment is basically arranged similarly to that of the third embodiment except that a cleaning liquid discharge member is additionally provided. Thus, in Figs. 8A and 8B, the components common to those in Figs. 5A and 5B are denoted by the same numerals and the detailed description thereof is omitted.

In the cleaning nozzle 25 of the fifth embodiment, a casing 2 is divided into five regions as shown in Figs. 8A and 8B, and the cleaning liquid discharge member 26 is additionally accommodated inwardly of a first cleaning liquid supply member 12 (on the side of an ultrasonic oscillator 8). This section constitutes a cleaning liquid discharge section 27. In the following description, a cleaning liquid discharge member 13 which is originally provided is referred to as a "first cleaning liquid supply member" and the cleaning liquid discharge member 26 which is newly added internally of the cleaning liquid supply member 12 is referred to as a "second cleaning liquid discharge member". A porous material which constitutes the second cleaning liquid discharge member 26 may be the same as that of the first cleaning liquid discharge member 13. Then, the cleaning liquid L on the substrate W is discharged also from the second cleaning liquid discharge member 26 likewise the first cleaning liquid discharge member 13.

Next, an example of the operation (sequence) of the cleaning nozzle 25 arranged as described above will be described using Fig. 9A to Fig. 9E. Note that, in the description of Figs. 9A to 9E, a substrate W is moved from right to left with respect to the cleaning nozzle 25 (the moving direction of the substrate is shown by arrows).

First, as shown in Fig. 9, when the left end of the substrate W approaches below a second cleaning liquid supply member 19, a cleaning liquid L is supplied from the second cleaning liquid supply member 19 onto the substrate W. At that time, no cleaning liquid is supplied from the first cleaning liquid supply member 12, and neither a discharge pump nor an ultrasonic oscillator 8 is operated. Further, even if the cleaning liquid L exists under the cleaning liquid discharge member 13 as shown in Fig. 9A, the cleaning liquid L is not yet discharged.

When the substrate W is further moved and the cleaning liquid L flows under the first cleaning liquid discharge member 13 and the ultrasonic oscillator 8 as shown in Fig. 9B, the ultrasonic oscillator 8 is operated to thereby start ultrasonic cleaning. However, the cleaning liquid L is not yet discharged from the first cleaning liquid discharge member 13.

Further, when the left end of the substrate W arrives below the second cleaning liquid discharge member 26 and the first cleaning liquid supply member 12 as shown in Fig. 9C, the first cleaning liquid supply member 12 starts to supply the cleaning liquid L. At the same time, the first cleaning liquid discharge member 13 starts to discharge the cleaning liquid having been used as well as the second cleaning liquid supply member 19 stops supplying the cleaning liquid L. When this stage is reached, the cleaning liquid L starts to steadily flow between the first cleaning liquid supply member 12 and the first cleaning liquid discharge member 13. That is, the first cleaning liquid supply member 12 achieves a role for steadily supplying the cleaning liquid L to the substrate W, and the second cleaning liquid supply member 19 achieves a role for rapidly wetting the substrate W with the cleaning liquid L at an early stage and a role for instantly filling the portion under the ultrasonic oscillator 8 with the cleaning liquid L.

Then, as shown in Fig. 9D, when the right end of the substrate W passes below the first cleaning liquid discharge member 13, the discharge of the cleaning liquid L from the cleaning liquid discharge member 13 and the ultrasonic oscillation are stopped, while the cleaning liquid is continuously supplied from the first cleaning liquid supply member 12. Further, the discharge of the cleaning liquid L from the second cleaning liquid discharge member 26 is started.

Finally, as shown in Fig. 9E, even if the right end of the substrate W passes below the ultrasonic oscillator 8, the supply of the cleaning liquid L from the first cleaning liquid supply member 12 and the discharge of the cleaning liquid L from the second cleaning liquid discharge member 26 are continued, and when the right end of the substrate W passes below the first cleaning liquid supply member 12, the supply of the cleaning liquid L from the first cleaning liquid supply member 12 and the discharge of the cleaning liquid L from the second cleaning liquid discharge member 26 are stopped. With this operation, the overall upper surface of the substrate can be subjected to the ultrasonic cleaning by the device.

When the above sequence is compared with that of the third embodiment shown in Fig. 6, the operation of the respective components is entirely the same between the steps in Fig. 6A to Fig. 6E and the steps in Fig. 9A to Fig. 9D and the operation thereof is different only at the step in Fig. 9E. That is, according to the cleaning nozzle 25 of the fifth embodiment, since the second cleaning liquid discharge member 26 is disposed adjacent to the first cleaning liquid supply member 12 for steadily supplying the cleaning liquid L, the cleaning liquid L remaining at the end of the substrate W where the cleaning thereof is finished (right end of the substrate W in Fig. 9E) can be completely discharged. As a result, the cleaning liquid L can be prevented from leaking and dropping from the substrate W at a final stage of cleaning and further particles are prevented from staying at the end of the substrate W.

### [Sixth embodiment]

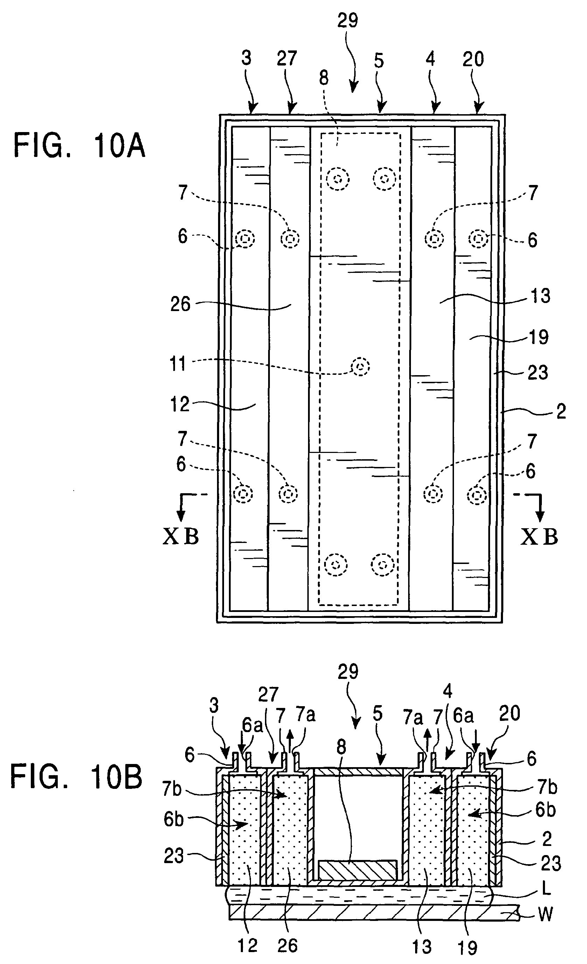

A sixth embodiment of the present invention will be described below with reference to Figs. 10A and 10B. Fig. 10A is a lower plan view of a cleaning nozzle (wet treatment nozzle) of the sixth embodiment and Fig 10B is a sectional view taken along the line X - X of Fig. 10A.

The cleaning nozzle of the sixth embodiment is basically arranged similarly to that of the fifth embodiment except that the hydrophobic layer is added to a part of the arrangement of the fifth embodiment. Thus, in Figs. 10A and 10B, the components common to those in Figs. 8A and 8B are denoted by the same numerals and the detailed description thereof is omitted.

The cleaning nozzle 29 of the sixth embodiment is arranged such that the inner periphery of an overall casing 2 is covered with the hydrophobic layer 23 composed of a hydrophobic material as shown in Figs. 10A and 10B.

An effect similar to that of the second and fourth embodiments capable of reliably preventing the leakage of the liquid to the outside of the nozzle can be obtained also in the cleaning nozzle 29 of the sixth embodiment.

While the nozzles exemplified in the first to sixth embodiments clean the front surface of a substrate, the cleaning nozzles of the following embodiments are nozzles for cleaning the back surface of a substrate. A front surface cleaning nozzle and a back surface cleaning nozzle may of course be used separately. However, when they are mounted on a single cleaning device, the front surface cleaning nozzle and the back surface cleaning nozzle may be independently driven. Otherwise, the front surface cleaning nozzle may be combined with the back surface cleaning nozzle with a slight gap defined therebetween in a fashion by which the movement of a substrate is not obstructed and a substrate may be inserted therebetween and cleaned thereby. In that case, when an ultrasonic oscillator is disposed to the front surface cleaning nozzle and ultrasonic oscillation is applied to a cleaning liquid, since the oscillation also is transmitted to the back surface of the substrate, no ultrasonic oscillator is necessary to the back surface cleaning nozzle. The above arrangement will be exemplified below.

### [Seventh embodiment]

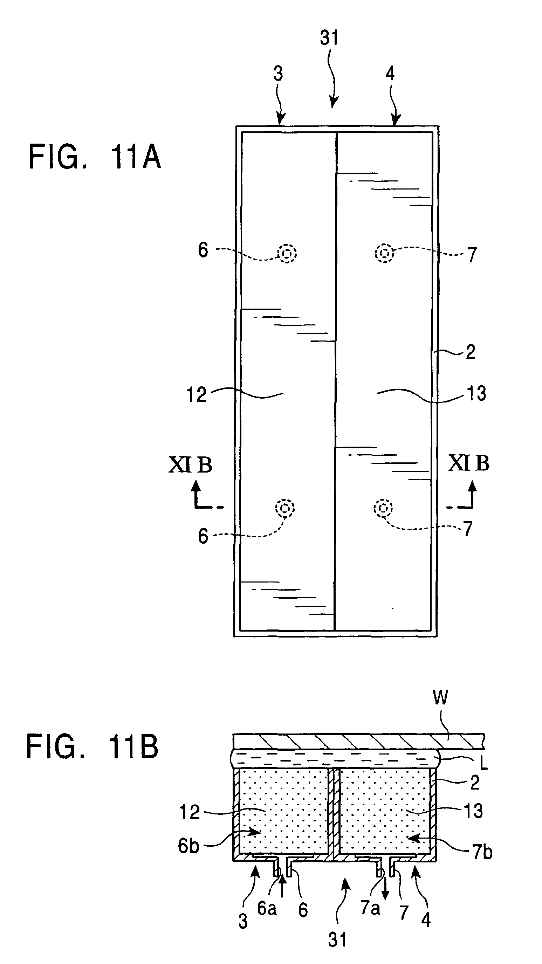

A seventh embodiment of the present invention will be described below with reference to Figs. 11A and 11B. Fig. 11A is an upper plan view of a cleaning nozzle (wet treatment nozzle) of the seventh embodiment and Fig 11B is a sectional view taken along the line XI - XI of Fig. 11A.

Also in this case, in Figs. 11A and 11B, the components common to those in Figs. 2A and 2B are denoted by the same numerals.

As shown in Figs. 11A and 11B, the cleaning nozzle 31 of the seventh embodiment has a casing 2 divided into two regions in the short side direction thereof and these regions are arranged as a cleaning liquid introduction section 3 and a cleaning liquid discharge section 4, respectively. Two cleaning liquid introduction pipes 6 (introduction paths), which are spaced apart from each other in the longitudinal direction of the nozzle, are disposed on the lower surface of the cleaning liquid introduction section 3, and two cleaning liquid discharge pipes 7 (discharge paths) are disposed on the lower surface of the cleaning liquid discharge section 4 likewise. The lower ends of the respective cleaning liquid introduction pipes 6 are opened so as to act as introduction ports 6a from which a cleaning liquid L (treatment liquid) is introduced, and the upper ends thereof are arranged as an introduction opening 6b which open toward a substrate W in the interior of the casing 2. Similarly, the lower ends of the respective cleaning liquid discharge pipes 7 are opened so as to act as discharge ports 7a from which the cleaning liquid L is discharged to the outside after it is used, and the upper ends thereof are arranged as a discharge opening 7b which opens toward the substrate W in the interior of the casing 2.

As shown in Fig. 11B, a cleaning liquid supply member 12 (treatment liquid supply member) composed of a porous material is accommodated in the interior of the introduction opening 6b. While various materials such as plastic, metal, ceramic and the like may be used as the porous material, a hydrophilic material can more preferably be used. Since the cleaning liquid supply member 12 is composed of the porous material, when the cleaning liquid L is supplied from the cleaning liquid introduction pipes 6 into the introduction opening 6b, the cleaning liquid L is supplied onto the substrate W through a multiplicity of through holes of the cleaning liquid supply member 12.

In contrast, a cleaning liquid discharge member 13 (treatment liquid discharge member) composed of a porous material also is accommodated in the interior of the discharge opening 7b. Since the cleaning liquid discharge member 13 is formed on the porous material, the used cleaning liquid L remaining on the substrate W is drawn from the multiplicity of through holes of the cleaning liquid discharge member 13 and discharged to the outside through the cleaning liquid discharge pipes 7.

The cleaning nozzle 31 of the seventy embodiment is a substrate back surface cleaning nozzle. Since the cleaning nozzle 31 is provided with the cleaning liquid supply member 12 and the cleaning liquid discharge member 13 each composed of the porous material similarly to the substrate surface cleaning nozzle, however, the cleaning liquid L is supplied to and discharged from the substrate W using the overall surfaces of these members 12 and 13 facing the substrate W. Accordingly, the cleaning liquid L is uniformly supplied onto the substrate W and no liquid reservoir is formed, whereby a cleaning efficiency can be improved. Further, no ultrasonic oscillator is required here, a simpler structure can be achieved.

### [Eighth embodiment]

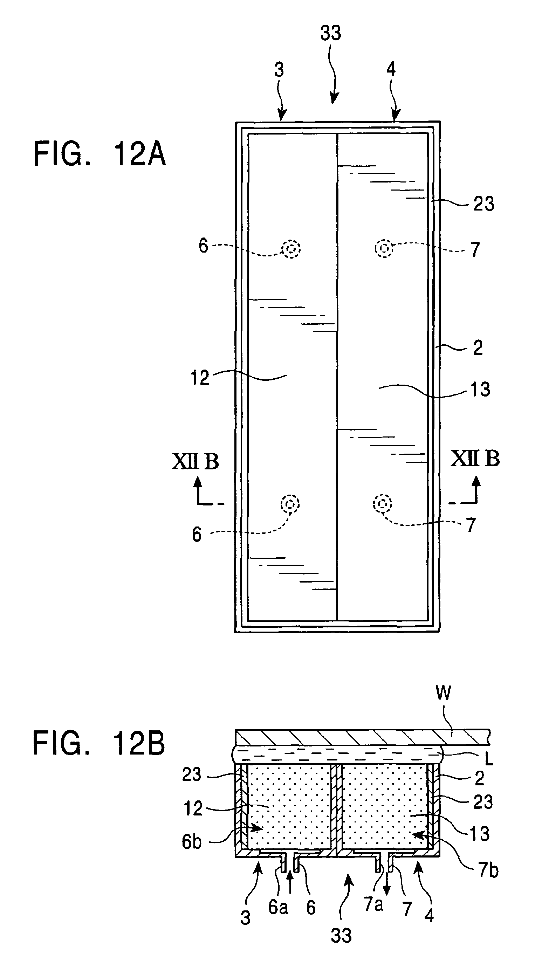

An eighth embodiment of the present invention will be described below with reference to Figs. 12A and 12B. Fig. 12A is an upper plan view of a cleaning nozzle (wet treatment nozzle) of the eighth embodiment and Fig 12B is a sectional view taken along the line XII - XII of Fig. 12A.

The cleaning nozzle of the eighth embodiment is basically arranged similarly to that of the seventh embodiment except that a hydrophobic layer is added to a part of the arrangement of the seventh embodiment. Thus, in Figs. 12A and 12B, the components common to those in Figs. 11A and 11B are denoted by the same numerals and the detailed description thereof is omitted.

The cleaning nozzle 33 of the eighth embodiment is arranged such that the inner periphery of an overall casing 2 is covered with the hydrophobic layer 23 composed of a hydrophobic material as shown in Figs. 12A and 12B. It is preferable to provide the hydrophobic layer also in the back surface cleaning nozzle, and with this arrangement the leakage of the liquid to the outside of the nozzle can be more reliably prevented.

### [Ninth embodiment]

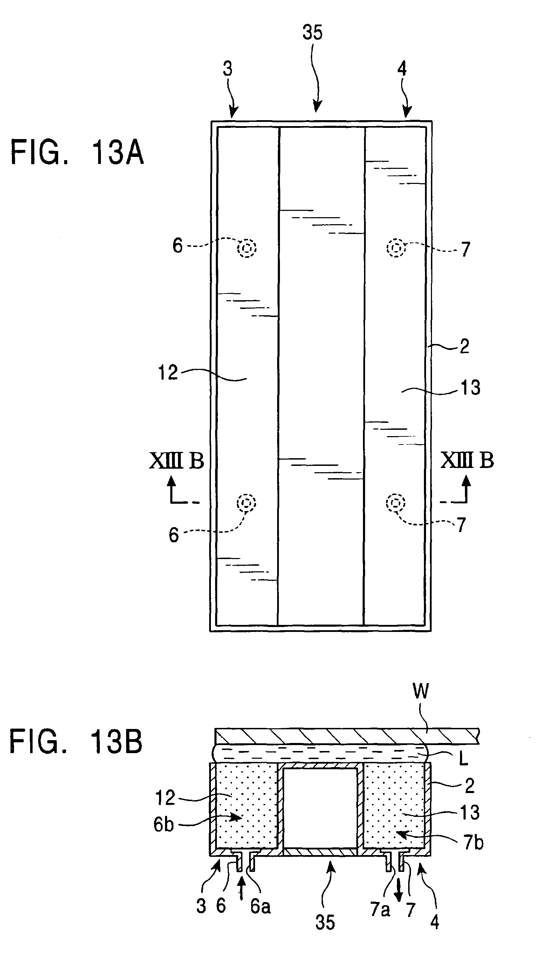

A ninth embodiment of the present invention will be described below with reference to Figs. 13A and 13B.

Fig. 13A is an upper plan view of a cleaning nozzle (wet treatment nozzle) of the ninth embodiment and Fig 13B is a sectional view taken along the line XIII - XIII of Fig. 13A.

The cleaning nozzle 35 of the ninth embodiment is a modification of the back surface cleaning nozzle. In the seventh and eighth embodiments, the cleaning liquid supply member is disposed adjacent to the cleaning liquid discharge member. In the ninth embodiment, however, a casing 2 may be divided into three regions and a cleaning liquid supply member 12 may be disposed spaced apart from a cleaning liquid discharge member 13 as shown in Figs. 13A and 13B.

### [Tenth embodiment]

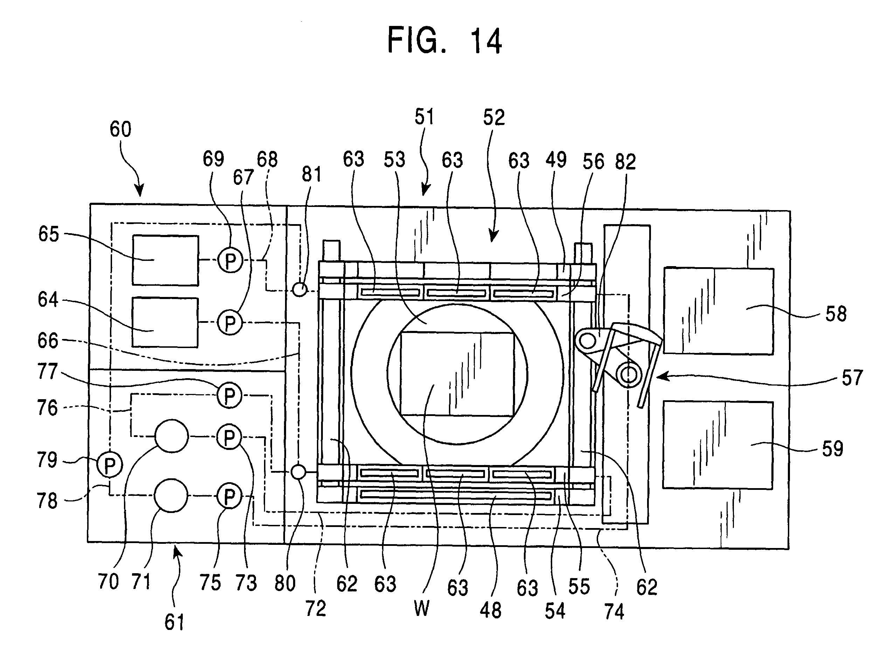

A tenth embodiment of the present invention will be described below with reference to Fig. 14.

The tenth embodiment is an example of a cleaning device (wet treatment apparatus) including any of the cleaning nozzles of the above embodiments. Fig. 14 is a view showing the schematic arrangement of a cleaning device of the tenth embodiment which cleans large glass substrates (hereinafter, simply referred to as "substrates") of, for example, about several hundreds of millimeters square, sheet by sheet.

In the figure, numeral 52 denotes a cleaning section, numeral 53 denotes a stage (substrate holding means), numerals 54, 55, 56 and 49 denote cleaning nozzles, numeral 57 denotes a substrate transfer robot, numeral 58 denotes a loader cassette, numeral 59 denotes an unloader cassette, numeral 60 denotes a hydrogen water/ozone water generating unit, numeral 61 denotes a cleaning liquid reproducing unit, and symbol W denotes a substrate.

As shown in Fig. 14, the cleaning section 52 is disposed on the upper surface of the apparatus at the central portion thereof and the stage 53 for holding the substrate W is disposed in the cleaning section 52. The stage 53 has a rectangular stepped portion which in conformity to the shape of the substrate W, the substrate W is put onto the stepped portion and held by the stage 53 with the surface of the substrate W flush with the surface of the stage 53. Further, a space is formed under the stepped portion and a substrate elevation shaft projects into the space from under the stage 53. A shaft drive source such as a cylinder or the like is disposed at the lower end of the substrate elevation shaft. When the substrate W is delivered by the substrate transfer robot 57 which will be described later, the substrate elevation shaft is moved up and down by actuating the cylinder, and the substrate W is moved up and down by the upward and downward movement of the shaft.

A pair of rack bases 62 are disposed at positions facing each other across the stage 53 and the cleaning nozzles 54, 55, 56, and 49 are disposed between the rack bases 62. The four cleaning nozzles 54, 55, 56, and 49 are disposed in parallel with each other and carry out cleaning by a different method, respectively. In the tenth embodiment, the cleaning nozzle 54 is an ultraviolet ray cleaning nozzle which supplies ozone to the substrate W as well as decomposes and removes mainly organic substances by irradiating ultraviolet rays from an ultraviolet lamp 48, the cleaning nozzle 55 is an ozone water ultrasonic cleaning nozzle for carrying out cleaning by applying ultrasonic oscillation by an ultrasonic oscillator 63 while supplying ozone water, the cleaning nozzle 56 is a hydrogen water ultrasonic cleaning nozzle for carrying out cleaning by applying ultrasonic oscillation by an ultrasonic oscillator 63 while supplying hydrogen water, and the cleaning nozzle 49 is a pure water rinse cleaning nozzle for carrying out rinse cleaning by supplying pure water. These four nozzles are sequentially moved above the substrate W along the rack bases 62 while keeping a predetermined gap between them and the substrate W, whereby the overall surface to be cleaned of the substrate W is cleaned by the four types of cleaning methods.

There are disposed sliders as cleaning nozzle moving means, respectively which can move along the linear guides on the respective rack bases 62. Support columns stand on the upper surfaces of the respective sliders, and both the ends of the respective cleaning nozzles 54, 55, 56, and 49 are fixed to these support columns. Drive sources such as motors or the like are mounted on the respective sliders so that the respective sliders can travel on the rack bases 62 by themselves. Then, the motors on the respective sliders are driven in response to a control signal supplied from the controller (not shown) of the apparatus, thereby horizontally moving the respective cleaning nozzles 54, 55, 56, and 49 individually. Further, drive sources such as cylinders (not shown) or the like are mounted on the support columns, and the heights of the respective cleaning nozzles 54, 55, 56, and 49, that is, the gaps between the respective cleaning nozzles 54, 55, 56, and 49 and the substrate W can be adjusted by the upward and downward movement of the support columns. The respective cleaning nozzles 54, 55, 56, and 49 are arranged as described in the above embodiments in detail and referred to as a so-called push/pull type nozzle (liquid saving type nozzle). However, only the ultrasonic oscillator 63 is illustrated here for the convenience of illustration, and a figure, which shows the divided state of a cleaning liquid introduction section, a cleaning liquid discharge section and the like is not omitted.

The hydrogen water/ozone water generating section 60 and the cleaning liquid reproducing section 61 are disposed on one side of the cleaning section 52. A hydrogen water manufacturing unit 64 and an ozone water manufacturing unit 65 are included in the hydrogen water/ozone water generating section 60. Any of the cleaning liquids can be made by dissolving a hydrogen gas and an ozone gas in pure water. Then, the hydrogen water made by the hydrogen water manufacturing unit 64 is supplied to the hydrogen water ultrasonic cleaning nozzle 56 by a liquid feed pump 67 disposed midway in a hydrogen water supply pipe 66. Likewise, the ozone water made by the ozone water manufacturing unit 65 is supplied to the ozone water ultrasonic cleaning nozzle 55 by a liquid feed pump 69 disposed midway in an ozone water supply pipe 68. Note that, pure water is supplied to the pure water rinse cleaning nozzle 49 from a pure water supply pipe (not shown) in a manufacturing line.

Further, the cleaning liquid reproducing section 61 includes filters 70 and 71 disposed thereto to remove particles and foreign substances contained in the cleaning liquid after it is used. The hydrogen water filter 70 for removing particles in hydrogen water and the ozone water filter 71 for removing particles in ozone water are disposed in a different system. That is, the used hydrogen water discharged from the discharge port of the hydrogen water ultrasonic cleaning nozzle 56 is collected in the hydrogen water filter 70 through a liquid feed pump 73 disposed midway in a hydrogen water collection pipe 72. Likewise, the used ozone water discharged from the discharge port of the ozone water ultrasonic cleaning nozzle 55 is collected in the hydrogen water filter 71 through a liquid feed pump 75 disposed midway in an ozone water collection pipe 74.

Then, the hydrogen water having passed through the hydrogen water filter 70 is supplied to the hydrogen water ultrasonic cleaning nozzle 56 by a liquid feed pump 77 disposed midway in a reproduced hydrogen water supply pipe 76. Likewise, the ozone water having passed through the ozone water filter 71 is supplied to the ozone water ultrasonic cleaning nozzle 55 by a liquid feed pump 79 disposed midway in a reproduced ozone water supply pipe 78. Further, the hydrogen supply pipe 66 is connected to the reproduced hydrogen water supply pipe 76 in front of the hydrogen water ultrasonic cleaning nozzle 56 so that introduction of new hydrogen water to the hydrogen water ultrasonic cleaning nozzle 56 and introduction of reproduced hydrogen water thereto can be switched through a valve 80. Likewise, the ozone water supply pipe 68 is connected to the reproduced ozone water supply pipe 78 in front of the ozone water ultrasonic cleaning nozzle 55 so that introduction of new ozone water to the ozone water ultrasonic cleaning nozzle 55 and introduction of reproduced ozone water thereto can be switched through a valve 81. Note that while particles are removed from the hydrogen water and the ozone water having passed through the respective filters 70 and 71, since the concentration of the gas contained in the liquid is lowered, the hydrogen water and the ozone water may be returned to the hydrogen water manufacturing unit 64 and the ozone water manufacturing unit 65 again through pipes so that a hydrogen gas and an ozone gas are replenished therewith.

The loader cassette 58 and the unloader cassette 59 are detachably disposed on the other side of the cleaning section 52. These two cassettes 58 and 59 are formed in the same shape and can accommodate a plurality of the substrates W therein. The loader cassette 58 accommodate the substrates W before they are cleaned and the unloader cassette 59 accommodate the substrates W after they are cleaned. Then, the substrate transfer robot 57 is disposed at a position midway between the cleaning section 52 and the loader cassette 58 and unloader cassette 59. The substrate transfer robot 57 has an arm 82, which includes a flexible link mechanism, at an upper portion thereof, the arm 82 can be pivoted as well as moved up and down, and the robot 57 can support and transfer the substrate W at the extreme end of the arm 82.

In the cleaning device 51 arranged as described above, the respective sections thereof are controlled by a controller except that various cleaning conditions, for example, the gap between the cleaning nozzles 54, 55, 56, and 49 and the substrate W, the moving speeds of the cleaning nozzles, the flow rate of the cleaning liquid, and the like are set by an operator, whereby the cleaning device 51 is automatically operated. Accordingly, in the use of the cleaning device 51, when the substrate W to be cleaned is set in the loader cassette 58 and the operator turns on a start switch, the substrate W is transferred from the loader cassette 58 onto the stage 53 by the substrate transfer robot 57 and automatically and sequentially subjected to ultraviolet cleaning, ozone water ultrasonic cleaning, hydrogen water ultrasonic cleaning and rinse cleaning. Then, after the substrate W is cleaned, it is accommodated in the unloader cassette 59 by the substrate transfer robot 57.

Since the four cleaning nozzles 54, 55, 56, and 49 carry out the cleaning treatments by the different methods of ultraviolet cleaning, ozone water ultrasonic cleaning, hydrogen water ultrasonic cleaning and rinse cleaning in the cleaning device 51 of the tenth embodiment, the various types of cleaning methods can be carried out by the one set of the apparatus.

Therefore, particles having a fine particle size are removed by, for example, the hydrogen water ultrasonic cleaning and the ozone water ultrasonic cleaning, and further finish cleaning is carried out while washing away the cleaning liquid deposited on the surface of the substrate. With this treatment, various types of substances can sufficiently be cleaned and removed. Further, since the cleaning device of the tenth embodiment is provided with the cleaning nozzles of the above embodiments, the consumption of the cleaning liquid can be reduced as compared with a conventional apparatus. Moreover, since no liquid reservoir is formed under the nozzles, the substrate can be cleaned very efficiently with a high degree of cleanness. Accordingly, a cleaning device, which is preferably applicable to the manufacturing lines of various types of electronic devices such as a semiconductor device, liquid crystal display panel and the like, can be realized.

The cleaning liquid supply member and the cleaning liquid discharge member each composed of the porous material are disposed on both the cleaning liquid introduction side and the cleaning liquid discharge side in the cleaning nozzles of the above embodiments and this arrangement is preferable. However, both of them need not necessarily be provided, and it is sufficient to provide at least the cleaning liquid supply member on the cleaning liquid introduction side because the porous material disposed on the liquid introduction side has a larger effect. Further, while the multiplicity of through holes of the cleaning liquid supply member are uniformly distributed and this is of course preferable, they may be distributed such that the number of through holes is reduced toward the extreme end of the nozzle. With this arrangement, since a less amount of a liquid flows out from the end of the nozzle, the leakage of the liquid to the outside of the nozzle can be reliably prevented.

Further, it is needless to say that, as to the specific arrangements such as the shape and size of the nozzle, the number of the cleaning liquid introduction pipe and the cleaning liquid discharge pipe, the locations where they are disposed, and the like, and the operation sequence of the nozzle, the designs thereof may suitably be changed when necessary. Further, while the example, in which the present invention is applied to the cleaning nozzle, is shown in the above embodiments, it is possible to apply the nozzle of the present invention to a wet treatment other than cleaning, for example, etching, resist removal, and the like.

As described above in detail, according to the wet treatment nozzle of the present invention, since the treatment liquid is supplied approximately uniformly from the overall surface of the treatment liquid supply member which faces a substrate to be treated, a liquid reservoir is not almost formed, whereby the efficiency of the wet treatment can be significantly improved as compared with the conventional arrangement. The wet treatment apparatus, which can carry out a wet treatment very efficiently with a high degree of cleanness, can be realized by the use of the nozzle.

## Claims

1. A wet treatment nozzle (1) for supplying a substrate (W) to be treated with a treatment liquid (L), comprising:
introduction paths (6) having introduction ports (6a), formed at one end thereof, for introducing the treatment liquid; discharge paths (7) having discharge ports (7a), formed at one end thereof, for discharging the treatment liquid after it is used to the outside,
an introduction opening (6b) disposed to the other ends of said introduction paths and opening toward the lower surface of the nozzle; a discharge opening (7b) disposed to the other ends of said discharge paths and opening toward the lower surface of the nozzle; **characterized by** a treatment liquid supply member (12), accommodated in said introduction opening, composed of a porous material and having a multiplicity of through holes for supplying the treatment liquid to the substrate.

2. A wet treatment nozzle according to claim 1, wherein a part of said treatment liquid supply member, on the side thereof which is at least in contact with the treatment liquid on the lower surface of the nozzle, is formed of a hydrophilic material.

3. A wet treatment nozzle according to claim 1 or 2, wherein an ultrasonic oscillation application means (8) is interposed between said introduction opening and said discharge opening to apply ultrasonic oscillation to the treatment liquid on the lower surface of the nozzle.

4. A wet treatment nozzle according to claim 1, 2 or 3, wherein a treatment liquid discharge member (13) having a multiplicity of through holes for discharging the treatment liquid from the lower surface of the nozzle to the outside is accommodated in said discharge opening.

5. A wet treatment nozzle according to claim 4, wherein a part of said treatment liquid discharge member, on the side thereof which is at least in contact with the treatment liquid on the lower surface of the nozzle, is formed of a hydrophilic material.

6. A wet treatment nozzle according to any preceding claim, wherein at least the periphery of said introduction opening including said treatment liquid supply member is formed of a hydrophobic material.

7. A wet treatment nozzle according to claim 4, wherein at least the periphery of said discharge opening including said treatment liquid discharge member is formed of a hydrophobic material.

8. A wet treatment nozzle according to claim 1, wherein a plurality of said introduction paths are disposed in parallel with each other, and said treatment liquid supply member is disposed to the opening of each of said plurality of introduction paths.

9. A wet treatment device, comprising:
a wet treatment nozzle according to claim 1; and
a draw and discharge means for drawing and discharging a treatment liquid, that has been in contact with a substrate under treatment, through an introduction opening after the treatment liquid is treated through discharge paths by controlling the difference between the pressure of the treatment liquid in contact with the substrate and the atmospheric pressure, to prevent the treatment liquid from flowing to the outside of discharge paths.

10. A wet treatment apparatus, comprising:
a wet treatment nozzle according to claim 1; and
a movement means for moving the wet treatment nozzle or a substrate under treatment, wherein the movement means is adapted to move the nozzle relative to the substrate, or the substrate relative to the nozzle, in order that the entire surface of the substrate is treatable.

11. A wet treatment apparatus according to claim 10, wherein at least one of a set of said wet treatment nozzles is disposable on one surface side of a substrate under treatment and another of said wet treatment nozzles is disposable on the other surface side thereof so that both surfaces of the substrate under treatment can be treated.

12. A wet treatment apparatus according to claim 11, wherein an ultrasonic oscillation application means (8) is disposed to any one of the set of wet treatment nozzles to apply ultrasonic oscillation to the treatment liquid on the substrate under treatment.

## Patentansprüche

1. Nassbehandlungsdüse (1) zum Zuleiten einer Behandlungsflüssigkeit (L) zu einem zu behandelnden Substrat (W), umfassend:
Einleitwege (6) mit an deren einem Ende ausgebildeten Einleitöffnungen (6a) zum Einleiten der Behandlungsflüssigkeit; Ausleitwege (7) mit an deren einem Ende ausgebildeten Ausleitöffnungen (7a) zum Ausleiten der Behandlungsflüssigkeit nach deren Benutzung zur Außenseite,
wobei eine Einleitöffnung (6b) an den anderen Enden der Einleitwege angeordnet ist und in Richtung der Unterseite der Düse mündet; eine Ausleitöffnung (7b) an den anderen Enden der Ausleitwege angeordnet ist und sich in Richtung der Unterseite der Düse öffnet;
**gekennzeichnet durch** ein Behandlungsflüssigkeits-Zuführelement (12), welches in der Einleitöffnung aufgenommen ist, zusammengesetzt aus einem porösen Werkstoff und ausgestattet mit einer Mehrzahl von Durchgangslöchern zum Zuführen der Behandlungsflüssigkeit zu dem Substrat.

2. Nassbehandlungsdüse nach Anspruch 1, bei der ein Teil des Behandlungsflüssigkeits-Zuführelements auf dessen zumindest mit der Behandlungsflüssigkeit auf der Unterseite der Düse in Berührung stehender Seite aus einem hydrophilen Werkstoff gebildet ist.

3. Nassbehandlungsdüse nach Anspruch 1 oder 2, wobei eine Ultraschall-Applikationseinrichtung (8) zwischen der Einleitöffnung und der Ausleitöffnung angeordnet ist, um die Behandlungsflüssigkeit an der Unterseite der Düse einer Ultraschallschwingung auszusetzen.

4. Nassbehandlungsdüse nach Anspruch 1, 2 oder 3, bei der ein Behandlungsflüssigkeits-Ausleitelement (13) mit einer Mehrzahl von Durchgangslöchern zum Ableiten der Behandlungsflüssigkeit von der Unterseite der Düse nach außen hin in der Ausleitöffnung aufgenommen ist.

5. Nassbehandlungsdüse nach Anspruch 4, bei der ein Teil des Behandlungsflüssigkeits-Ausleitelements auf deren zumindest mit der Behandlungsflüssigkeit auf der Unterseite der Düse in Berührung stehenden Seite aus einem hydrophilen Werkstoff gebildet ist.

6. Nassbehandlungsdüse nach einem der vorhergehenden Ansprüche, bei der zumindest der Umfang der Einleitöffnung, die das Behandlungsflüssigkeits-Zuführelement enthält, aus einem hydrophoben Material gebildet ist.

7. Nassbehandlungsdüse nach Anspruch 4, bei der zumindest der Umfang der Ausleitöffnung, die das Behandlungsflüssigkeits-Ausleitelement enthält, aus einem hydrophoben Material gebildet ist.

8. Nassbehandlungsdüse nach Anspruch 1, bei der mehrere Einleitwege parallel zueinander angeordnet sind und das Behandlungsflüssigkeits-Zuführelement an der Öffnung jedes der mehreren Einleitwege angeordnet ist.

9. Nassbehandlungsvorrichtung, umfassend:
eine Nassbehandlungsdüse nach Anspruch 1; und
eine Ansaug- und Ausleiteinrichtung zum Ansaugen und Ausleiten einer Behandlungsflüssigkeit, die in Berührung mit einem behandelten Substrat war, durch eine Einleitöffnung, nachdem die Behandlungsflüssigkeit behandelt ist, durch Ausleitwege, in dem Druckdifferenz zwischen der mit dem Substrat in Berührung befindlichen Behandlungsflüssigkeit und dem atmosphärischen Druck gesteuert wird, um zu verhindern, dass die Behandlungsflüssigkeit aus den Ausleitwegen nach Außen strömt.

10. Nassbehandlungsvorrichtung, umfassend:
eine Nassbehandlungsdüse nach Anspruch 1; und
eine Bewegungseinrichtung zum Bewegen der Nassbehandlungsdüse oder eines zu behandelnden Substrats, wobei die Bewegungseinrichtung dazu ausgebildet ist, die Düse relativ zu dem Substrat zu bewegen, oder das Substrat relativ zu der Düse zu bewegen, um die gesamte Substratoberfläche behandelbar zu machen.

11. Nassbehandlungsvorrichtung nach Anspruch 10, bei der zumindest eine aus einer Menge der Nassbehandlungsdüsen auf einer Oberflächenseite eines zu behandelnden Substrats anordbar ist, und eine weitere der Nassbehandlungsdüsen auf der anderen Oberflächenseite anordbar ist, so dass beide Flächen des zu behandelnden Substrats behandelt werden können.

12. Nassbehandlungsvorrichtung nach Anspruch 11, bei der eine Ultraschall-Applikationseinrichtung (8) an jeder aus der Menge von Nassbehandlungsdüsen angeordnet ist, um der Behandlungsflüssigkeit auf dem behandelten Substrat eine Ultraschallschwingung zu verleihen.

## Revendications

1. Buse de traitement humide (1) permettant d'appliquer sur un substrat (W) à traiter un liquide de traitement (L), comprenant : des chemins d'introduction (6), comportant des orifices d'introduction (6a) ménagés à une extrémité de ceux-ci, pour introduire le liquide de traitement ; des chemins d'évacuation (7), comportant des orifices d'évacuation (7a) ménagés à une extrémité de ceux-ci, pour évacuer le liquide de traitement vers l'extérieur une fois qu'il a été utilisé,
une ouverture d'introduction (6b) disposée vers les autres extrémités desdits chemins d'introduction et débouchant vers la surface inférieure de la buse ; une ouverture d'évacuation (7b) disposée vers les autres extrémités desdits chemins d'évacuation et débouchant vers la surface inférieure de la buse ; **caractérisée par** un élément d'alimentation en liquide de traitement (12), logé dans ladite ouverture d'introduction, constitué d'un matériau poreux et comportant une pluralité de trous traversants afin de délivrer le liquide de traitement au substrat.

2. Buse de traitement humide selon la revendication 1, dans laquelle une partie dudit élément d'alimentation en liquide de traitement, sur son côté qui est au moins en contact avec le liquide de traitement sur la surface inférieure de la buse, est constituée d'un matériau hydrophile.

3. Buse de traitement humide selon l'une quelconque des revendications 1 ou 2, dans laquelle des moyens applicateurs d'oscillation ultrasonore (8) sont intercalés entre ladite ouverture d'introduction et ladite ouverture d'évacuation afin d'appliquer une oscillation ultrasonore au liquide de traitement sur la surface inférieure de la buse.

4. Buse de traitement humide selon l'une quelconque des revendications 1, 2 ou 3, dans laquelle un élément d'évacuation de liquide de traitement (13), comportant une pluralité de trous traversants pour évacuer le liquide de traitement vers l'extérieur à partir de la surface inférieure de la buse, est logé dans ladite ouverture d'évacuation.

5. Buse de traitement humide selon la revendication 4, dans laquelle une partie dudit élément d'évacuation de liquide de traitement, sur son côté qui est au moins en contact avec le liquide de traitement sur la surface inférieure de la buse, est constituée d'un matériau hydrophile.

6. Buse de traitement humide selon l'une quelconque des revendications précédentes, dans laquelle au moins la périphérie de ladite ouverture d'introduction incluant ledit élément d'alimentation en liquide de traitement est constituée d'un matériau hydrophobe.

7. Buse de traitement humide selon la revendication 4, dans laquelle au moins la périphérie de ladite ouverture d'évacuation incluant ledit élément d'évacuation de liquide de traitement est constituée d'un matériau hydrophobe.

8. Buse de traitement humide selon la revendication 1, dans laquelle une pluralité desdits chemins d'introduction sont disposés parallèlement les uns aux autres, et ledit élément d'alimentation en liquide de traitement est disposé vers l'ouverture de chacun de ladite pluralité de chemins d'introduction.

9. Dispositif de traitement humide, comprenant :
une buse de traitement humide selon la revendication 1 ; et
des moyens d'aspiration et d'évacuation permettant d'aspirer et d'évacuer un liquide de traitement, qui a été en contact avec un substrat en cours de traitement, par l'intermédiaire d'une ouverture d'introduction une fois que le liquide de traitement a été traité au travers des chemins d'évacuation, en contrôlant la différence entre la pression du liquide de traitement en contact avec le substrat et la pression atmosphérique, afin d'empêcher le liquide de traitement de s'écouler vers l'extérieur des chemins d'évacuation.

10. Appareil de traitement humide, comprenant :
une buse de traitement humide selon la revendication 1 ; et
des moyens de déplacement permettant de déplacer la buse de traitement humide ou un substrat en cours de traitement, dans lequel les moyens de déplacement sont conçus pour déplacer la buse par rapport au substrat, ou le substrat par rapport à la buse, afin que toute la surface du substrat puisse être traitée.

11. Appareil de traitement humide selon la revendication 10, dans lequel au moins l'une d'un ensemble desdites buses de traitement humide peut être disposée sur le côté de surface d'un substrat en cours de traitement, et une autre desdites buses de traitement humide peut être disposée sur l'autre côté de surface de ceux-ci, de telle sorte que les deux surfaces du substrat en cours de traitement puissent être traitées.

12. Appareil de traitement humide selon la revendication 11, dans lequel des moyens applicateurs d'oscillation ultrasonore (8) sont disposés sur l'une quelconque de l'ensemble de buses de traitement humide afin d'appliquer une oscillation ultrasonore au liquide de traitement sur le substrat en cours de traitement.
